# EUROPEAN PATENT SPECIFICATION

(11) **EP 2 977 705 B1**
(45) Date of publication and mention of the grant of the patent: **12.12.2018**
(21) Application number: 15176914.8
(22) Date of filing: 15.07.2015
(51) Int. Cl.: F28F 3/12, H01L 23/46, F28D 1/02, F28F 3/04, F28D 1/03, F28F 1/08

(54) **HEAT TRANSFER PLATE**
WÄRMEÜBERTRAGUNGSPLATTE
PLAQUE DE TRANSFERT DE CHALEUR

(30) Priority: 22.07.2014 US 201414337454
(43) Date of publication of application: 27.01.2016
(73) Proprietor: Hamilton Sundstrand Space Systems International, Inc., Windsor Locks, CT 06096 (US)
(72) Inventor: STRANGE, Jeremy M., Windsor, CT Connecticut 06095 (US); DIEP, Chuong H., Enfield, CT Connecticut 06082 (US); BANACH, Thomas E., Barkhamsted, CT Connecticut 06063 (US)
(74) Representative: Dehns

(56) References cited:
- WO-A1-96/34421
- WO-A1-2006/066875
- DE-A1- 10 345 695
- DE-C1- 3 739 585
- US-A- 5 582 241
- US-A1- 2013 220 587

## Description

### BACKGROUND

### 1. Field

The present disclosure relates to heat transfer systems, more specifically to heat transferring structures and plates.

### 2. Description of Related Art

Electrical components in circuitry (e.g., aircraft or spacecraft circuits) include heat generating components and require sufficient heat transfer away from the heat generating components in order to function properly. Many mechanisms have been used to accomplish cooling, e.g., fans, heat transfer plates, and actively cooled devices such as tubes or plates including tubes therein for passing coolant adjacent a hot surface. While circuitry continues to shrink in size, developing heat transfer devices sufficient to move heat away from the components is becoming increasingly difficult.

WO 2006/066875 A1 discloses a heat exchanger comprising a number of parallel tubes and web-like portions interconnecting said tubes in the form of a heat transfer plate having the features in the preamble of claim 1.

Such conventional methods and systems have generally been considered satisfactory for their intended purpose. However, there is still a need in the art for improved heat transfer devices. Recent advancements in metal based additive manufacturing techniques allow the creation of micro-scale, geometrically complex devices not previously possible with conventional machining. The use of conductive metal and innovative geometries offers many benefits to devices cooling high heat flux energy sources. The present disclosure provides a solution for this need.

### SUMMARY

A heat transfer plate includes a body defining a fluid inlet and fluid outlet. The body also defines a plurality of channels defined within the body in fluid communication between the fluid inlet and the fluid outlet, wherein the channels are fluidly isolated from one another between the fluid inlet and the fluid outlet. The channels are square wave shaped defined by a square waveform to provide multiple impingement zones on opposed faces of the body to facilitate heat transfer.

The body can define a unitary matrix fluidly isolating the channels from one another between the fluid inlet and the fluid outlet. The device can be configured to mount to an electrical component (e.g., a microchip or other suitable device).

The body can be about 0.08 inches (about 2 mm) thick or any other suitable thickness. The body can define at least one fluid inlet for each channel. In certain embodiments, the body can define at least one fluid outlet for each channel.

The square wave shaped channels disposed adjacent each other can define the square waveforms off-phase from each other.

The plurality of channels can be defined in a series of rows grouped together in at least one branch. Each channel can be off phase of an adjacent channel by 90 degrees. The body can include aluminum or any other suitable material.

In some aspects of this disclosure, a method includes forming a heat transfer device by forming a body defining fluid inlet and fluid outlet and a plurality of channels defined within the body in fluid connection between the fluid inlet and the fluid outlet, wherein the channels are fluidly isolated from one another between the fluid inlet and the fluid outlet. The channels are square wave shaped defined by a square waveform to provide multiple impingement zones on opposed faces of the body to facilitate heat transfer. Forming includes forming the heat transfer device by additive manufacturing.

In at least one aspect of this disclosure, a system includes at least one electrical component and at least one heat transfer device including a body defining fluid inlet and fluid outlet and a plurality of channels defined within the body in fluid connection between the fluid inlet and the fluid outlet, wherein the channels are fluidly isolated from one another between the fluid inlet and the fluid outlet.

These and other features of the systems and methods of the subject disclosure will become more readily apparent to those skilled in the art from the following detailed description taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, exemplary embodiments thereof will be described in detail herein below by way of example only and with reference to certain figures, wherein:
Fig. 1 is a plan view of an exemplary embodiment of a heat transfer device in accordance with this disclosure, showing fluid flow represented by arrows flowing therethrough;
Fig. 2 is a schematic perspective view of a fluid volume inside a portion the heat transfer device of Fig. 1;
Fig. 3 is a cross-sectional side elevation view of the heat transfer device of Fig. 1, showing the cross-section taken through line 3-3;
Fig. 4 is a cross-sectional side elevation view of a portion of the cross-sectional illustration of the heat transfer device of Fig. 3, showing the impingement zones with flow traveling therethrough; and
Fig. 5 is a cross-sectional side elevation view of a portion of the cross-sectional illustration of the heat transfer device of Fig. 3, showing the impingement zones.

### DETAILED DESCRIPTION

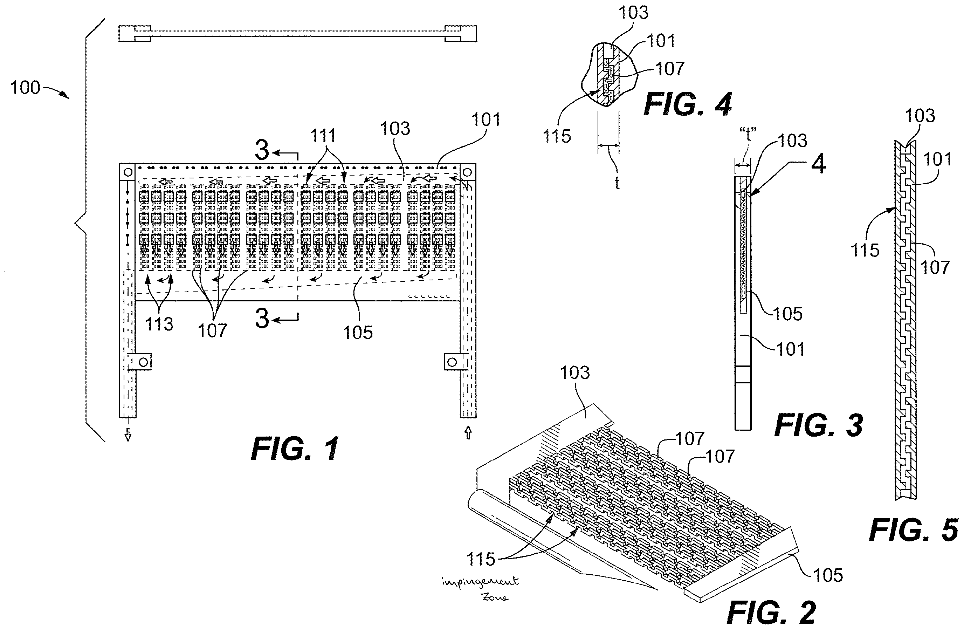

Reference will now be made to the drawings wherein like reference numerals identify similar structural features or aspects of the subject disclosure. For purposes of explanation and illustration, and not limitation, an illustrative view of an exemplary embodiment of a heat transfer device in accordance with the disclosure is shown in Fig. 1 and is designated generally by reference character 100. Other views and aspects of the exemplary heat transfer device 100 are shown in Figs. 2-4. The systems and methods described herein can be used to transfer heat from a heat source (e.g., an electrical component) to a cooling fluid passing through the heat transfer device 100, thereby cooling the heat source.

Referring generally to Fig. 1, a heat transfer device 100 includes a body 101 defining fluid inlet 103 and fluid outlet 105. The body 101, or a portion thereof, also defines a plurality of channels 107 defined within the body 101 in fluid connection between the fluid inlet 103 and the fluid outlet 105. The channels 107 are fluidly isolated from one another between the fluid inlet 103 and the fluid outlet 105. Referring to Fig. 2, the body 101 can define a unitary matrix fluidly isolating the channels 107 from one another between the fluid inlet 103 and the fluid outlet 105. As shown in Fig. 1, the fluid inlet 103 can be a reducing shape plenum (reducing in the direction of flow), or any other suitable shape. Also as shown, the fluid outlet can include an expanding shape plenum (expanding in the direction of flow), or any other suitable shape.

The device 100 can be configured to mount to an electrical component (e.g., a microchip or other suitable device) to transfer heat therefrom and to cool the electrical component. Any other suitable heat transfer application using device 100 is contemplated herein.

Referring to Fig. 3, the body 101 can have a thickness "t" of about 0.05 inches (about 1.25 mm) to about 0.5 (about 12.5 mm) inches. In some embodiments, the body 101 can be about 0.08 inches (about 2 mm) thick. The body 101 can have any other suitable thickness and/or cross-sectional design. For example, the body 101 can include a variable thickness.

The body 101 can define at least one channel fluid inlet 111 for each channel 107 such that each fluid channel connects to fluid inlet 103 at the channel fluid inlet 111. The channel fluid inlets 111 can include any suitable size and/or shape, and can differ from one another in any suitable manner. The body 101 can also define at least one channel fluid outlet 113 for each channel 107 such that each fluid channel connects to fluid outlet 105 at the channel fluid inlet 113. The channel fluid outlets 113 can include any suitable size and/or shape, and can differ from one another in any suitable manner. In this respect, flow can enter the device 100 at the inlet 103, travel into the channels 107 through channel inlets 111, pass through the channels 107, and exit the channels 107 through channel outlets 113 into outlet 105.

The channels 107 can be square wave shaped as shown in Figs. 3 and 4 and defined by a square waveform to provide multiple impingement zones 115 on opposed surfaces of the body 101 to facilitate heat transfer on the heat source that the device 100 is attached to. The square wave shaped channels 107 disposed adjacent each other can define the square waveforms off-phase from each other as best shown in Fig. 2. The channels 107 can have a height (amplitude of the waveform) that is less than the thickness of the body 101, but any suitable height or cross-sectional area within that thickness is contemplated herein. Figs. 4 and 5 show cross sectional areas of one of the flow channels as shown in Fig. 3.

As shown, the plurality of channels 107 can be defined in a series of rows and/or branches. Any other suitable arrangement is contemplated herein. Each channel can be off phase of an adjacent channel by 90 degrees, 180 degrees, or any other suitable off-phase.

The body 101 can include aluminum or any other suitable heat conducting material. The material or combination of materials that form the body 101 can be selected to account for thermal transfer properties to efficiently transfer heat to the fluid in the body 101.

As disclosed herein, the heat transfer device 100 efficiently transfers heat from a heat source by allowing a coolant (e.g., water or any suitable refrigerant) to efficiently pass through the body 101 via the channels 107. The design of the channels 107 allows for a longer path within the body 101 and additional time and impingement locations for heat to transfer to the coolant compared to alternate configurations. Such compact designs allow for much more efficient cooling of small heat generating devices.

In another aspect of this disclosure, a method includes forming a heat transfer device 100 by forming a body 101 that defines a plurality of fluidly isolated channels 107 within the body, each channel 107 connecting to the a fluid inlet 103 and a fluid outlet 105. This can include forming the heat transfer device 101 by additive manufacturing. Any other suitable process for forming the device 100 can be used without departing from the scope of this disclosure.

The methods, devices, and systems of the present disclosure, as described above and shown in the drawings, provide for a heat transfer device with superior properties including increased heat transfer. While the apparatus and methods of the subject disclosure have been shown and described with reference to embodiments, those skilled in the art will readily appreciate that changes and/or modifications may be made thereto without departing from the scope of the subject disclosure as defined by the claims.

## Claims

1. A heat transfer plate, comprising:
a body (101) defining a fluid inlet (103) and fluid outlet (105); and
a plurality of channels (107) defined within the body in fluid communication between the fluid inlet and the fluid outlet, wherein the channels are fluidly isolated from one another between the fluid inlet and the fluid outlet;
**characterised in that** the channels (107) are square wave shaped and defined by a square waveform to provide multiple impingement zones (115) on opposed faces of the body (101) to facilitate heat transfer.

2. The plate of claim 1, wherein the body (101) defines a unitary matrix fluidly isolating the channels (107) from one another between the fluid inlet and the fluid outlet.

3. The plate of claim 1 or 2, wherein the device is configured to mount to an electrical component.

4. The plate of any preceding claim, wherein the body (101) is about 0.08 inches thick.

5. The plate of any preceding claim, wherein the body (101) defines at least one fluid inlet (111) for each channel (107).

6. The plate of any preceding claim, wherein the body (101) defines at least one fluid outlet (113) for each channel (107).

7. The plate of claim 1, wherein the square wave shaped channels (107) disposed adjacent each other define the square waveforms off-phase from each other.

8. The plate of any preceding claim, wherein the plurality of channels (107) are defined in a series of rows grouped together in at least one branch.

9. The plate of any preceding claim, wherein each channel (107) is off phase of an adjacent channels by 90 degrees.

10. The plate of any preceding claim, wherein the body (101) includes aluminum.

11. A method, comprising:
forming a heat transfer plate by forming a body (101) defining fluid inlet (103) and fluid outlet (105) and a plurality of channels (107) defined within the body in fluid connection between the fluid inlet and the fluid outlet, wherein the channels are fluidly isolated from one another between the fluid inlet and the fluid outlet, wherein the channels (107) are square wave shaped and defined by a square waveform to provide multiple impingement zones (115) on opposed faces of the body (101) to facilitate heat transfer, and
wherein forming includes forming the heat transfer plate by additive manufacturing.

## Patentansprüche

1. Wärmeübertragungsplatte, die Folgendes umfasst:
einen Körper (101), der einen Fluideinlass (103) und einen Fluidauslass (105) definiert; und
eine Vielzahl von Kanälen (107), die innerhalb des Körpers in Fluidverbindung zwischen dem Fluideinlass und dem Fluidauslass definiert ist, wobei die Kanäle zwischen dem Fluideinlass und dem Fluidauslass fluidisch voneinander isoliert sind;
**dadurch gekennzeichnet, dass** die Kanäle (107) quadratisch wellenförmig sind und durch eine quadratische Wellenform definiert sind, um mehrere Prallbereiche (115) auf gegenüberliegenden Seiten des Körpers (101) bereitzustellen, um die Wärmeübertragung zu erleichtern.

2. Platte nach Anspruch 1, wobei der Körper (101) eine unitäre Matrix definiert, die die Kanäle (107) zwischen dem Fluideinlass und dem Fluidauslass fluid voneinander isoliert.

3. Platte nach Anspruch 1 oder 2, wobei die Vorrichtung konfiguriert ist, um auf einer elektrischen Komponente aufzusitzen.

4. Platte nach einem der vorhergehenden Ansprüche, wobei der Körper (101) circa 0,2032 cm (0,08 in) dick ist.

5. Platte nach einem der vorhergehenden Ansprüche, wobei der Körper (101) mindestens einen Fluideinlass (111) für jeden Kanal (107) definiert.

6. Platte nach einem der vorhergehenden Ansprüche, wobei der Körper (101) mindestens einen Fluidauslass (113) für jeden Kanal (107) definiert.

7. Platte nach Anspruch 1, wobei die quadratisch wellenförmigen Kanäle (107), die benachbart zueinander angeordnet sind, die quadratische Wellenform phasenverschoben voneinander definieren.

8. Platte nach einem der vorhergehenden Ansprüche, wobei die Vielzahl von Kanälen (107) in einer Abfolge von Reihen definiert ist, die in mindestens einem Zweig gruppiert sind.

9. Platte nach einem der vorhergehenden Ansprüche, wobei jeder Kanal (107) von einem benachbarten Kanal um 90 Grad phasenverschoben ist.

10. Platte nach einem der vorhergehenden Ansprüche, wobei der Körper (101) Aluminium beinhaltet.

11. Verfahren, das Folgendes umfasst:
Bilden einer Wärmeübertragungsplatte durch Bilden eines Körpers (101), der einen Fluideinlass (103) und einen Fluidauslass (105) und eine Vielzahl von Kanälen (107) definiert, die innerhalb des Körpers in Fluidverbindung zwischen dem Fluideinlass und dem Fluidauslass stehen, wobei die Kanäle zwischen dem Fluideinlass und dem Fluidauslass fluidisch voneinander isoliert sind, wobei die Kanäle (107) quadratisch wellenförmig sind und durch eine quadratische Wellenform definiert sind, um mehrere Prallbereiche (115) auf gegenüberliegenden Seiten des Körpers (101) bereitzustellen, um eine Wärmeübertragung zu erleichtern, und
wobei das Bilden das Bilden der Wärmeübertragungsplatte durch additive Fertigung beinhaltet.

## Revendications

1. Plaque de transfert de chaleur, comprenant :
un corps (101) définissant une entrée de fluide (103) et une sortie de fluide (105) ; et
une pluralité de canaux (107) définis dans le corps en communication fluidique entre l'entrée de fluide et la sortie de fluide, dans laquelle les canaux sont fluidiquement isolés les uns des autres entre l'entrée de fluide et la sortie de fluide ;
**caractérisée en ce que** les canaux (107) sont en forme d'onde carrée et définis par une forme d'onde carrée pour fournir de multiples zones d'impact (115) sur des faces opposées du corps (101) afin de faciliter le transfert de chaleur.

2. Plaque selon la revendication 1, dans laquelle le corps (101) définit une matrice unitaire isolant fluidiquement les canaux (107) les uns des autres entre l'entrée de fluide et la sortie de fluide.

3. Plaque selon la revendication 1 ou 2, dans laquelle le dispositif est configuré pour être monté sur un composant électrique.

4. Plaque selon une quelconque revendication précédente, dans laquelle le corps (101) fait environ 0,08 pouce d'épaisseur.

5. Plaque selon une quelconque revendication précédente, dans laquelle le corps (101) définit au moins une entrée de fluide (111) pour chaque canal (107).

6. Plaque selon une quelconque revendication précédente, dans laquelle le corps (101) définit au moins une sortie de fluide (113) pour chaque canal (107).

7. Plaque selon la revendication 1, dans laquelle les canaux en forme d'onde carrée (107) disposés de manière adjacente les uns aux autres définissent les formes d'onde carrées hors de phase les unes des autres.

8. Plaque selon une quelconque revendication précédente, dans laquelle la pluralité de canaux (107) sont définis dans une série de rangées regroupées en au moins une branche.

9. Plaque selon une quelconque revendication précédente, dans laquelle chaque canal (107) est hors de phase d'un canal adjacent de 90 degrés.

10. Plaque selon une quelconque revendication précédente, dans laquelle le corps (101) inclut de l'aluminium.

11. Procédé, comprenant :
la formation d'une plaque de transfert de chaleur en formant un corps (101) définissant une entrée de fluide (103) et une sortie de fluide (105) et une pluralité de canaux (107) définis dans le corps en raccordement fluidique entre l'entrée de fluide et la sortie de fluide, dans lequel les canaux sont fluidiquement isolés les uns des autres entre l'entrée de fluide et la sortie de fluide, dans lequel les canaux (107) sont en forme d'onde carrée et définis par une forme d'onde carrée pour fournir de multiples zones d'impact (115) sur des faces opposées du corps (101) afin de faciliter le transfert de chaleur, et
dans lequel la formation inclut la formation de la plaque de transfert de chaleur par fabrication additive.
